# EUROPÄISCHE PATENTSCHRIFT

(11) **EP 1 145 589 B1**
(45) Veröffentlichungstag und Bekanntmachung des Hinweises auf die Patenterteilung: **03.03.2004**
(21) Anmeldenummer: 99932663.0
(22) Anmeldetag: 07.05.1999
(51) Int. Cl.: H04Q 11/04, H04N 7/14, H03M 7/00, H04J 3/22

(54) **VERFAHREN UND ANORDNUNG ZUR ECHTZEIT-ÜBERTRAGUNG VON KOMPRIMIERTEN DATEN**
METHOD AND ARRANGEMENT FOR REAL-TIME TRANSMISSION OF COMPRESSED DATA
PROCEDE ET SYSTEME DE TRANSMISSION EN TEMPS REEL DE DONNEES COMPRIMEES

(30) Priorität: 20.05.1998 DE 19822796
(43) Veröffentlichungstag der Anmeldung: 17.10.2001
(73) Patentinhaber: SIEMENS AKTIENGESELLSCHAFT, 80333 München (DE)
(72) Erfinder: HULTSCH, Wolfgang, D-81369 München (DE)
(86) Internationale Anmeldenummer: PCT/DE1999/001392
(87) Internationale Veröffentlichungsnummer: WO 1999/060708

(56) Entgegenhaltungen:
- WO-A-96/18272
- US-A- 5 251 313
- WUNNAVA S ET AL: "NETWORK BASED VIRTUAL VISUAL CENTER (VVC) DEVELOPMENT SCHEMES" ANNUAL REVIEW OF COMMUNICATIONS, Bd. 49, 1. Januar 1996 (1996-01-01), Seiten 687-692, XP000620830 ISSN: 0886-229X
- TANAKA T ET AL: "MOBILE COMPUTING USING PERSONAL HANDY-PHONE SYSTEM (PHS)" IEICE TRANSACTIONS ON COMMUNICATIONS, Bd. 80-B, Nr. 8, 1. August 1997 (1997-08-01), Seiten 1118-1124, XP000723078 ISSN: 0916-8516

## Beschreibung

Die Erfindung bezieht sich auf ein Verfahren und eine Anordnung zur Echtzeit-Übertragung von komprimierten Daten.

Die Übertragung von komprimierten Daten im Telekommunikationsbereich erfolgt üblicherweise auf leitungsgebundenen Verbindungen. So werden beispielsweise Videodaten im Zuge einer Videokonferenz oder bei Videotelefonie von ISDN-Endgeräten (Integrated Services Digital Network) erzeugt und ausschließlich über leitungsvermittelte (circuit switched) Verbindungen eines ISDN-Festnetzes mit konstanter Datenrate, d.h. auf einer oder zwei 64kbit/s-Strecken, in Echtzeit übertragen. In Abhängigkeit der Bewegung der Objekte im aufgenommenen Bild erzeugt die für die Datenkompression zuständige Kodiereinrichtung Datenströme mit stark schwankenden Datenraten. Zur Übertragung im ISDN-Festnetz werden die Datenströme - mit den schwankenden Datenraten - durch geeignetes Hinzufügen von Fülldaten (bit stuffing) zu den komprimierten Videodaten auf die jeweilige konstante Datenrate gebracht. Eine Echtzeit-Übertragung der mit Fülldaten aufbereiteten komprimierten Daten in ein Kommunikationsnetz mit Datenströmen variabler Datenrate, z.B. einem Mobil-Kommunikationsnetz mit einer Funkschnittstelle, ist unwirtschaftlich, da die auf der Funkschnittstelle zur Verfügung stehende, kostbare Übertragungsbandbreite hinsichtlich der Nutzdatenübertragung möglichst effizient genutzt werden muß.

Es ist Aufgabe der Erfindung, ein Verfahren und eine Anordung anzugeben, durch das bzw. die eine wirtschaftliche Echtzeit-Übertragung von komprimierten Daten von einem Kommunikationsnetz zu einem anderen Kommunikationsnetz erzielbar ist.

Diese Aufgabe wird gemäß der Erfindung hinsichtlich des Verfahrens durch die Merkmale des Patentanspruchs 1 und hinsichtlich der Anordnung durch die Merkmale des Patentanspruchs 6 gelöst. Weiterbildungen der Erfindung sind den Unteransprüchen zu entnehmen.

Gemäß dem Gegenstand der Erfindung werden Nutzdaten und Fülldaten als Datenstrom mit konstanter Datenrate über eine leitungsvermittelte Verbindung eines ersten Kommunikationsnetzes empfangen, die in dem Datenstrom konstanter Datenrate enthaltenen Fülldaten entfernt, die in dem Datenstrom konstanter Datenrate enthaltenen Nutzdaten umformatiert und als Datenstrom mit variabler Datenrate über eine paketorientierte Verbindung eines zweiten Kommunikationsnetzes gesendet. Der Vorteil der Erfindung besteht in der effizienten Ausnutzung der Übertragungsbandbreite durch Entfernen der überflüssigen Fülldaten, die im Datenstrom konstanter Datenrate über die leitungsvermittelte Verbindung empfangen werden, und Umformatieren der Nutzdaten für den Datenstrom variabler Datenrate über die paketorientierte Verbindung. Dies wirkt sich ganz besonders günstig aus, wenn die Echtzeit-Übertragung der komprimierten Daten in ein Mobil-Kommunikationsnetz mit einer bezüglich der Übertragungsbandbreite begrenzten Funkschnittstelle führt. An Stelle der aussortierten Fülldaten werden Nutzdaten gemäß der für die Teilnehmerverbindung zur Verfügung stehenden variablen Übertragungsbandbreite - d.h. auch in Datenströmen mit höheren Datenraten - übertragen.

Gemäß einer Weiterbildung der Erfindung werden Qualitätsdaten zur Kennzeichnung der Übertragungsqualität der paketorientierten Verbindung dem zweiten Kommunikationsnetz mitgeteilt. Damit wird erreicht, daß im zweiten Kommunikationsnetz eine gleichmäßig gute Übertragung der komprimierten Daten - ausschließlich Nutzdaten - im Vergleich zur Übertragungsqualität des ersten Kommunikationsnetzes vorliegt.

Vorzugsweise werden als Qualitätsdaten eine mittlere Datenrate und/oder eine Maximaldatenrate für den Datenstrom mit variabler Datenrate ermittelt. Durch die Einstellung der mittleren Datenrate und/oder der Maximaldatenrate ist eine akzeptable Wiedergabequalität der komprimierten Nutzdaten beim Empfänger erzielbar, da die Echtzeit-Übertragung nur sehr geringe Verzögerungszeiten, z.B. im Millisekundenbereich, gestattet.

Zur Kennzeichnung der Übertragungsqualität wird gemäß einer weiteren bevorzugten Ausgestaltung der Erfindung die Güte des für den Datenstrom mit variabler Datenrate benutzten Übertragungskanals - erkennbar an der zulässigen Bitfehlerrate - verwendet.

Als besonders günstig in Bezug auf eine wirtschaftliche und effiziente Funkressourcenausnutzung hat sich die Erfindung erwiesen, wenn komprimierte Videodaten als Datenstrom mit konstanter Datenrate über die leitungsvermittelte Verbindung eines leitungsgebundenen Kommunikationsnetzes empfangen und als Datenstrom mit variabler Datenrate über die paketorientierte Verbindung eines Mobil-Kommunikationsnetzes gesendet werden.

Die Anordnung gemäß dem Gegenstand der Erfindung weist eine Einrichtung auf, mit
- Mittel zum Empfangen von Nutzdaten und Fülldaten, die als Datenstrom mit konstanter Datenrate über eine leitungsvermittelte Verbindung eines ersten Kommunikationsnetzes eintreffen,
- Mittel zum Entfernen der in dem Datenstrom konstanter Datenrate enthaltenen Fülldaten und zum Umformatieren der in dem Datenstrom konstanter Datenrate enthaltenen Nutzdaten,
- Mittel zum Senden der umformatierten Nutzdaten als Datenstrom mit variabler Datenrate über eine paketorientierte Verbindung eines zweiten Kommunikationsnetzes.

Nachstehend wird die Erfindung anhand eines Ausführungsbeispiels unter Bezugnahme auf eine Figur näher erläutert, die eine Anordnung zur Echtzeit-Übertragung von komprimierten Daten zwischen einem ersten Kommunikationsnetz und einem zweiten Kommunikationsnetz zeigt.

Im vorliegenden Beispiel sei angenommen, daß das erste Kommunikationsnetz von einem Festnetz ISDN (Integrated Services Digital Network) und das zweite Kommunikationsnetz von einem Mobil-Kommunikationsnetz UMTS (Universal Mobile Telecommunication System) gebildet werden. Weiterhin sei angenommen, daß eine Einrichtung SSU mit den Merkmalen gemäß der Erfindung für die Echtzeit-Übertragung der komprimierten Daten von dem Festnetz ISDN zum Mobil-Kommunikationsnetz UMTS als eigenständige Einrichtung zwischen den beiden Kommunikationsnetzen angeordnet ist. Ebenso könnte sie auch Bestandteil des Festnetzes ISDN oder des Mobil-Kommunikationsnetzes UMTS sein. Die Erfindung ist darüber hinaus nicht auf die beispielhaften Kommunikationsnetze ISDN, UMTS beschränkt, sondern für andere Kommunikationsnetze anwendbar. Das Festnetz ISDN und das Mobil-Kommunikationsnetz UMTS weisen jeweils eine Kontrolleinrichtung NC bzw. RNC auf, die netzseitig die Schnittstelle zur Einrichtung SSU für die Datenübertragung bildet. Für den Fall, daß die Einrichtung SSU Bestandteil des Festnetzes ISDN oder des Mobil-Kommunikationsnetzes UMTS ist, würde sie vorzugsweise in der Kontrolleinrichtung NC bzw. RNC angeordnet sein. Jede Kontrolleinrichtung RNC, NC weist eine Steuereinheit RST, ST sowie eine Speichereinheit RSP, SP auf. Die Einrichtung SSU verfügt ebenfalls über eine Steuereinheit CTR, mit der eine Empfangseinheit RC an der Schnittstelle zur Kontrolleinrichtung NC und eine Sendeeinheit TR an der Schnittstelle zur Kontrolleinrichtung RNC verbunden sind.

Bei den komprimierten Daten handelt es sich beispielsweise um komprimierte Videodaten, die von einem Videokoder als Datenstrom DS1 mit konstanter Datenrate DRk - beispielsweise 64 kbit/s oder 2*64 kbit/s - erzeugt und über zumindest eine leitungsvermittelte Verbindung des Festnetzes ISDN übertragen werden. Dabei wird die konstante Datenrate DRk durch Hinzufügen von Fülldaten F zu Nutzdaten N generiert (bit stuffing). Die Nutzdaten N enthalten die für die Videokonferenz erforderlichen Daten, die von einem Kommunikationsendgerät des leitungsgebundenen Festnetzes ISDN erzeugt und in Echtzeit zu einem Kommunikationsendgerät des Mobil-Kommunikationsnetzes UMTS transportiert werden. Um eine effiziente und wirtschaftliche Ausnutzung der Funkressourcen - insbesondere der bezüglich der Übertragungsbandbreite begrenzten Funkschnittstelle - bei der Echtzeit-Übertragung der komprimierten Videodaten auch in dem Mobil-Kommunikationsnetz UMTS zu ermöglichen, erfolgt durch die Einrichtung SSU eine Umwandlung des empfangenen Datenstroms DS1 konstanter Datenrate DRk in einen Datenstrom DS2 variabler Datenrate DRv. Die Empfangseinheit RC empfängt die über die leitungsvermittelte Verbindung ankommenden Fülldaten F und Nutzdaten N. Die Steuereinheit CTR erkennt sowie entfernt die Fülldaten F aus dem Datenstrom DS1 und formatiert nur die verbleibenden Nutzdaten N zu einem Datenstrom DS2 mit variabler Datenrate DRv um. Die Sendeeinheit TR sendet nur Nutzdaten N im aufbereiteten Datenstrom DS2 variabler Datenrate DRv über eine paketorientierte Verbindung des Mobil-Kommunikationsnetzes UMTS. Das Umformatieren erfolgt durch das Einbetten der Nutzdaten N - d.h. der Videodaten - in das Übertragungsformat beispielsweise eines paketorientierten GPRS-Dienstes (General Packet Radio Service) oder der paketorientierten ATM-Zellen (Asynchronous Transfer Mode). Auf diese Weise kann die durch die Fülldaten F entstandene Datenlücke - im Datenstrom DS1 mit konstanter Datenrate DRk - für die Übertragung weiterer Videodaten oder anderer Nutzdaten N im Datenstrom DS1 variabler Datenrate DRv ausgenutzt werden.

Von der Steuereinheit CTR der Einrichtung SSU werden Qualitätsdaten QoS (Quality of Service) zur Kennzeichnung der Übertragungsqualität der paketorientierten Verbindung bestimmt und der Kontrolleinrichtung RNC des Mobil-Kommunikationsnetzes UMTS über die Sendeeinheit TR mitgeteilt. Damit wird erreicht, daß im zweiten Kommunikationsnetz UMTS eine gleichmäßig gute Übertragung der komprimierten Daten - ausschließlich Nutzdaten N im Datenstrom DS2 variabler Datenrate DRv - im Vergleich zur Übertragungsqualität des ersten Kommunikationsnetzes ISDN herrscht. Zu den Qualitätsdaten QoS gehört beispielsweise die Angabe der Güte des für den Datenstrom DS2 benutzten Übertragungskanals im Mobil-Kommunikationsnetz UMTS, erkennbar an der zulässigen Bitfehlerrate. Die Echtzeitanforderungen an die Übertragung der Videodaten mittels paketorientiertem Verfahren im Mobil-Kommunikationsnetz UMTS spiegelt sich in einer mittleren Datenrate und/oder einer Maximaldatenrate wieder, die als Qualitätsdaten QoS für den Datenstrom mit variabler Datenrate ermittelt werden. Durch die Einstellung der mittleren Datenrate und/oder der Maximaldatenrate ist eine akzeptable Wiedergabequalität der komprimierten Videodaten beim Empfänger erzielbar, da die Echtzeit-Übertragung nur sehr geringe Verzögerungszeiten, z.B. im Millisekundenbereich, gestattet.

Die Maximaldatenrate entspricht der Gesamtdatenrate im Festnetz ISDN, die sich aus mehreren einzelnen Datenraten ergibt, die bei Übertragung des Videodatenstroms über mehrere leitungsvermittelte Verbindungen benutzt werden. Für das Beispiel der zwei 64 kbit/s Übertragungsstrecken ist die Gesamtdatenrate 128 kbit/s. Die mittlere Datenrate ist durch die Datenmenge gekennzeichnet, die von dem Videokoder innerhalb eines definierten Zeitraums während einer typischen Videokonferenz erzeugt wird. Vorzugsweise wird diese mittlere Datenrate auf der Basis einer Punkt-zu-Punkt-Videokonferenz - d.h. wenig bis unbewegter Hintergrund, keine besonderen Lippenbewegungen sowie Gestik und Mimik des Teilnehmers - empirisch ermittelt und als konfigurierbarer Parameter der Steuereinheit CTR der Einrichtung SSU zur Verfügung gestellt. Bei Verwendung eines Kodecs gemäß dem Standard ITU-T H.263 und unbewegtem Hintergrund beträgt die mittlere Datenrate einer Punkt-zu-Punkt-Videokonferenz beispielsweise etwa 10 kbit/s bei QCIF Bildformat und 176*144 Bildpunkte.

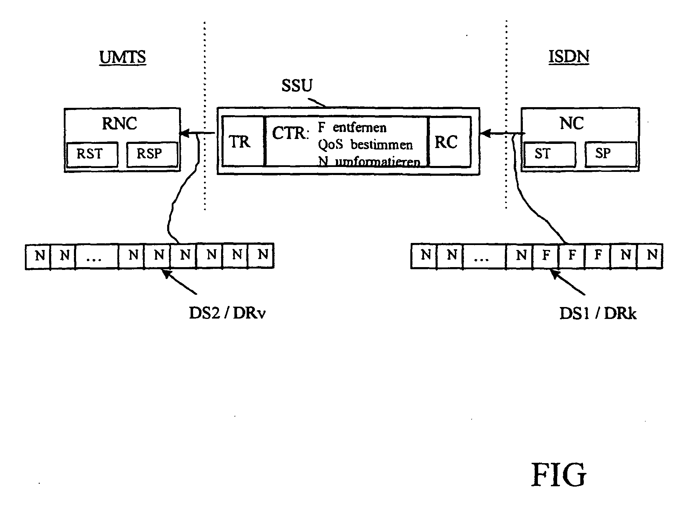

## Patentansprüche

1. Verfahren zur Echtzeit-Übertragung von komprimierten Daten, bei dem
- Nutzdaten (N) und Fülldaten (F) als Datenstrom (DS1) mit konstanter Datenrate (DRk) über eine leitungsvermittelte Verbindung eines ersten Kommunikationsnetzes (ISDN) empfangen werden,
- die in dem Datenstrom (DS1) konstanter Datenrate (DRk) enthaltenen Fülldaten (F) entfernt werden,
- die in dem Datenstrom (DS1) konstanter Datenrate (DRk) enthaltenen Nutzdaten (N) umformatiert und als Datenstrom (DS2) mit variabler Datenrate (DRv) über eine paketorientierte Verbindung eines zweiten Kommunikationsnetzes (UMTS) gesendet werden.

2. Verfahren nach Anspruch 1, bei dem
Qualitätsdaten (QoS) zur Kennzeichnung der Ubertragungsqualität der paketorientierten Verbindung dem zweiten Kommunikationsnetz (UMTS) mitgeteilt werden.

3. Verfahren nach Anspruch 2, bei dem
als Qualitätsdaten (QoS) eine mittlere Datenrate und/oder eine Maximaldatenrate für den Datenstrom (DS2) mit variabler Datenrate (DRv) ermittelt werden.

4. Verfahren nach Anspruch 2 oder 3, bei dem
die Güte eines für den Datenstrom (DS2) mit variabler Datenrate (DRv) benutzten Übertragungskanals zur Kennzeichnung der Übertragungsqualität verwendet wird.

5. Verfahren nach einem der vorhergehenden Ansprüche, bei dem komprimierte Videodaten als Datenstrom (DS1) mit konstanter Datenrate (DRk) über die leitungsvermittelte Verbindung eines leitungsgebundenen Kommunikationsnetzes (ISDN) empfangen und als Datenstrom (DS2) mit variabler Datenrate (DRv) über die paketorientierte Verbindung eines Mobil-Kommunikationsnetzes (UMTS) gesendet werden.

6. Anordnung zur Echtzeit-Übertragung von komprimierten Daten, mit einer Einrichtung (SSU), die aufweist
- Mittel (RC) zum Empfangen von Nutzdaten (N) und Fülldaten (F), die als Datenstrom (DS1) mit konstanter Datenrate (DRk) über eine leitungsvermittelte Verbindung eines ersten Kommunikationsnetzes (ISDN) eintreffen,
- Mittel (CTR) zum Entfernen der in dem Datenstrom (DS1) konstanter Datenrate (DRk) enthaltenen Fülldaten (F) und zum Umformatieren der in dem Datenstrom (DS1) konstanter Datenrate (DRk) enthaltenen Nutzdaten (N),
- Mittel (TR) zum Senden der umformatierten Nutzdaten als Datenstrom (DS2) mit variabler Datenrate (DRv) über eine paketorientierte Verbindung eines zweiten Kommunikationsnetzes (UMTS).

7. Anordnung nach Anspruch 6, bei der
die Einrichtung (SSU) zwischen einem leitungsgebundenen Kommunikationsnetz (ISDN) und einem Mobil-Kommunikationsnetz (UMTS) angeordnet ist.

8. Anordnung nach Anspruch 6 oder 7, bei der
die Einrichtung (SSU) zur Übertragung von komprimierten Videodaten vorgesehen ist.

## Claims

1. Method for real-time transmission of compressed data, in which
- useful data (N) and filling data (F) are received as a data stream (DS1) with a constant data rate (DRk) via a circuit-switched connection of a first communications network (ISDN),
- the filling data (F) contained in the data stream (DS1) with the constant data rate (DRk) are removed,
- the useful data (N) contained in the data stream (DS1) with the constant data rate (DRk) are reformatted and sent as a data stream (DS2) with a variable data rate (DRv) via a packet-oriented connection of a second communications network (UMTS).

2. Method according to Claim 1, in which
quality data (QoS) for identifying the transmission quality of the packet-oriented connection are communicated to the second communications network (UMTS).

3. Method according to Claim 2, in which
an average data rate and/or a maximum data rate for the data stream (DS2) with the variable data rate (DRv) are determined as quality data (QoS).

4. Method according to Claim 2 or 3, in which
the quality factor of a transmission channel used for the data stream (DS2) with the variable data rate (DRv) is used for identifying the transmission quality.

5. Method as claimed in one of the preceding claims, in which
compressed video data are received as the data stream (DS1) with the constant data rate (DRk) via the circuit-switched connection of a line-connected communications network (ISDN) and are sent as the data stream (DS2) with the variable data rate (DRv) via the packet-oriented connection of a mobile communications network (UMTS).

6. Arrangement for real-time transmission of compressed data, having a device (SSU) which has
- means (RC) for receiving useful data (N) and filling data (F) which arrive as a data stream (DS1) with a constant data rate (DRk) via a circuit-switched connection of a first communications network (ISDN),
- means (CTR) for removing the filling data (F) contained in the data stream (DS1) with the constant data rate (DRk) and for reformatting the useful data (N) contained in the data stream (DS1) with the constant data rate (DRk),
- means (TR) for sending the reformatted useful data as a data stream (DS2) with a variable data rate (DRv) via a packet-oriented connection of a second communications network (UMTS).

7. Arrangement according to Claim 6, in which
the device (SSU) is arranged between a line-connected communications network (ISDN) and a mobile communications network (UMTS).

8. Arrangement according to Claim 6 or 7, in which
the device (SSU) is provided for the transmission of compressed video data.

## Revendications

1. Procédé pour la transmission en temps réel de données comprimées, dans lequel
- on reçoit des données utiles (N) et des données de remplissage (F) comme flux de données (DS1) au débit de données constant (DRk) par l'intermédiaire d'une liaison à commutation de circuits d'un premier réseau de communication (ISDN),
- on élimine les données de remplissage (F) contenues dans le flux de données (DS1) au débit de données constant (DRk),
- on reformate les données utiles (N) contenues dans le flux de données (DS1) au débit de données constant (DRk) et on les envoie comme flux de données (DS2) au débit de données variable (DRv) par l'intermédiaire d'une liaison à commutation de paquets d'un deuxième réseau de communication (UMTS).

2. Procédé selon la revendication 1, dans lequel on fournit au deuxième réseau de communication (UMTS) des données de qualité (QoS) destinées à **caractériser** la qualité de transmission de la liaison à commutation de paquets.

3. Procédé selon la revendication 2, dans lequel on détermine comme données de qualité (QoS) un débit de données moyen et/ou un débit de données maximal pour le flux de données (DS2) au débit de données variable (DRv).

4. Procédé selon la revendication 2 ou 3, dans lequel on utilise la qualité d'un canal de transmission utilisé pour le flux de données (DS2) au débit de données variable (DRv) pour **caractériser** la qualité de transmission.

5. Procédé selon l'une des revendications précédentes, dans lequel on reçoit des données vidéo comprimées comme flux de données (DS1) au débit de données constant (DRk) par l'intermédiaire de la liaison à commutation de circuits d'un réseau de communication à commutation de circuits (ISDN) et on les émet comme flux de données (DS2) au débit de données variable (DRv) par l'intermédiaire de la liaison à commutation de paquets d'un réseau de communication mobile (UMTS).

6. Système pour la transmission en temps réel de données comprimées avec un dispositif (SSU) qui comporte
- des moyens (RC) pour recevoir des données utiles (N) et des données de remplissage (F) qui arrivent comme flux de données (DS1) au débit de données constant (DRk) par l'intermédiaire d'une liaison à commutation de circuits d'un premier réseau de communication (ISDN),
- des moyens (CTR) pour éliminer les données de remplissage (F) contenues dans le flux de données (DS1) au débit de données constant (DRk) et pour reformater les données utiles (N) contenues dans le flux de données (DS1) au débit de données constant (DRk),
- des moyens (TR) pour envoyer les données utiles reformatées comme flux de données (DS2) au débit de données variable (DRv) par l'intermédiaire d'une liaison à commutation de paquets d'un deuxième réseau de communication (UMTS).

7. Système selon la revendication 6, dans lequel le dispositif (SSU) est placé entre un réseau de communication à commutation de circuits (ISDN) et un réseau de communication mobile (UMTS).

8. Système selon la revendication 6 ou 7, dans lequel le dispositif (SSU) est prévu pour la transmission de données vidéo comprimées.
